# EUROPEAN PATENT SPECIFICATION

(11) **EP 4 617 342 B1**
(45) Date of publication and mention of the grant of the patent: **10.06.2026**
(21) Application number: 25162130.6
(22) Date of filing: 06.03.2025
(51) Int. Cl.: C09K 11/77

(54) **SILICATE FLUORESCENT MATERIAL, LIGHT EMITTING DEVICE, AND METHOD FOR PRODUCING SILICATE FLUORESCENT MATERIAL**
FLUORESZIERENDES SILIKATMATERIAL, LICHTEMITTIERENDE VORRICHTUNG UND VERFAHREN ZUR HERSTELLUNG DES FLUORESZIERENDEN SILIKATMATERIALS
MATÉRIAU FLUORESCENT DE SILICATE, DISPOSITIF ÉLECTROLUMINESCENT ET PROCÉDÉ DE PRODUCTION DE MATÉRIAU FLUORESCENT DE SILICATE

(30) Priority: 11.03.2024 JP 2024036809
(43) Date of publication of application: 17.09.2025
(73) Proprietor: NICHIA CORPORATION, Anan-shi, Tokushima 774-8601 (JP)
(72) Inventor: YOKOYAMA, Yudai, Anan-shi (JP); WAKUI, Sadakazu, Anan-shi (JP)
(74) Representative: Vossius & Partner Patentanwälte Rechtsanwälte mbB

(56) References cited:
- US-A1- 2019 144 744
- US-A1- 2023 123 606
- RUEGENBERG FREIA ET AL: "Chasing Down the Eu 2+ Ions: The Delicate Structure-Property Relationships in the Ultra-Narrow Band Phosphor", ADVANCED OPTICAL MATERIALS, vol. 9, no. 24, 1 December 2021 (2021-12-01), DE, XP093298646, ISSN: 2195-1071, DOI: 10.1002/adom.202101643

## Description

### CROSS-REFERENCE TO RELATED PATENT APPLICATION

This application claims priority to Japanese Patent Application No. 2024-036809, filed on March 11, 2024.

### TECHNICAL FIELD

The present disclosure relates to a silicate fluorescent material, a light emitting device, and a method for producing a silicate fluorescent material.

### BACKGROUND

Light emitting devices, such as those used in backlights of display devices, are needed to have a wider range of color reproducibility. In order to widen the range of color reproducibility, it may be necessary for fluorescent materials to have a light emission peak with a narrower wavelength width (full width at half maximum) in the light emission spectrum.

Examples of green-emitting fluorescent materials used in light emitting devices include a β-SiAlON fluorescent material having a composition represented by the formula Si_{6-z}Al_{z}O_{z}N_{8-z} (wherein z satisfies 0 < z ≤ 4.2) and using europium as an activating element.

For green-emitting fluorescent materials, Japanese Translation of PCT International Application Publication No. 2019-527760 discloses an orthosilicate fluorescent material using europium as an activating element. US 2023/123606 A1 discloses various Eu doped alkali lithosilicates.

### SUMMARY

In order to widen the range of color reproducibility, green-emitting fluorescent materials are needed to have a light emission peak with a narrow full width at half maximum in the light emission spectrum, high light emission intensity, and high light resistance with reduced photodegradation caused by continuous irradiation with excitation light.

One object of the present disclosure is to provide a silicate fluorescent material having a light emission peak with a narrow full width at half maximum in the light emission spectrum, high light emission intensity, and high light resistance, and a light emitting device and a method for producing a silicate fluorescent material using the same.

According to a first aspect of the present disclosure, a silicate fluorescent material has a composition represented by the following formula (1):

A¹_{1-w-x}A²_{w}M¹ₓ(Li₃SiO₄):Eu_{y} (1)

wherein A¹ represents at least one first alkali element selected from the group consisting of Rb and Cs, A² represents at least one second alkali element selected from the group consisting of K, Na, and Li, M¹ represents at least one element selected from the group consisting of Mg, Ca, Sr, Ba, Y, and La, and w, x, and y satisfy 0 < w < 1.0, 0 < x ≤ 0.125, w+x ≤ 1.0, and 0 < y ≤ 0.08.

According to a second aspect of the present disclosure, a light emitting device includes: the silicate fluorescent material; and a light emitting element irradiating the silicate fluorescent material with excitation light and having a light emission peak wavelength in a range of 300 nm or more and 500 nm or less.

According to a third aspect of the present disclosure, a method for producing a silicate fluorescent material includes: mixing raw materials including a first compound containing at least one first alkali element A¹ selected from the group consisting of Rb and Cs, a second compound containing at least one second alkali element A² selected from the group consisting of K, Na, and Li, a third compound containing at least one element M¹ selected from the group consisting of Mg, Ca, Sr, Ba, Y, and La, a fourth compound containing Li, a fifth compound containing Si, and a sixth compound containing Eu, wherein at least one compound of the first compound to the sixth compound is an oxide, to obtain a raw material mixture, wherein the first alkali element A¹ contained in the first compound, the second alkali element A² contained in the second compound, the element M¹ contained in the third compound, Li contained in the fourth compound, Si contained in the fifth compound, and Eu contained in the sixth compound satisfy molar ratios in a composition represented by the following formula (1); and first heat-treating the raw material mixture at a first temperature in the range of 400°C or higher and 800°C or lower in a reducing atmosphere to obtain a first heat-treated product having the composition represented by the following formula (1):

A¹_{1-w-x}A²_{w}M¹ₓ(Li₃SiO₄):Eu_{y} (1)

wherein w, x, and y satisfy 0 < w < 1, 0 < x ≤ 0.125, w+x ≤ 1.0, and 0 < y ≤ 0.08.

The present disclosure allows for providing a silicate fluorescent material having a light emission peak with a narrow full width at half maximum in the light emission spectrum, high light emission intensity, and high light resistance, and a light emitting device and a method for producing a silicate fluorescent material using the same.

### BRIEF DESCRIPTION OF THE DRAWINGS

FIG. 1 is a schematic cross-sectional view showing an example of a light emitting device according to the present disclosure.
FIG. 2 is a graph showing light emission spectra of silicate fluorescent materials according to Examples 1 to 4 and Comparative Example 1.
FIG. 3 is a graph showing light emission spectra of silicate fluorescent materials according to Example 7 and Comparative Example 2.
FIG. 4 is a graph showing light emission maintenance rates of silicate fluorescent materials according to Examples 2 and 7 and Comparative Example 1 after being continuously irradiated with excitation light for 500 hours.
FIG. 5 is a graph showing thermoluminescence spectra of silicate fluorescent materials according to Examples 3 and 7 and Comparative Example 1.
FIG. 6 is a graph showing X-ray diffraction patterns of silicate fluorescent materials according to Examples 1 to 11 and Comparative Examples 1 and 2.
FIG. 7 is a graph showing X-ray diffraction patterns of silicate fluorescent materials according to Examples 1 to 4, with the diffraction angle 2θ (°) from 37° to 37.8° enlarged.

### DETAILED DESCRIPTION

The silicate fluorescent material according to the present disclosure, and the light emitting device and method for producing a silicate fluorescent material using the same, are described below on the basis of embodiments. The embodiments described below are exemplifications for giving a concrete form to the technical idea of the present disclosure, and the present disclosure is not limited to the following silicate fluorescent material, light emitting device, and method for producing a silicate fluorescent material. In the present specification, the relationship between color names and chromaticity coordinates, and the relationship between wavelength ranges of light and color names of monochromatic light are in accordance with Japanese Industrial Standard (JIS) Z8110. In the present specification, the full width at half maximum refers to a wavelength width at which the light emission intensity is 50% of the light emission intensity at the light emission peak wavelength showing the maximum light emission intensity in the light emission spectrum. In this specification, the "fluorescent material" is used in the same meaning as a "fluorescent phosphor".

The silicate fluorescent material has a composition represented by the following formula (1):

A¹_{1-w-x}A²_{w}M¹ₓ(Li₃SiO₄):Eu_{y} (1)

wherein A¹ represents at least one first alkali element selected from the group consisting of Rb and Cs, A² represents at least one second alkali element selected from the group consisting of K, Na, and Li, M¹ represents at least one element selected from the group consisting of Mg, Ca, Sr, Ba, Y, and La, and w, x, and y satisfy 0 < w < 1.0, 0 < x ≤ 0.125, w+x ≤ 1.0, and 0 < y ≤ 0.08.

The silicate fluorescent material has a crystal structure including a four-coordinate tetrahedral structure composed of silicate (SiO₄) and lithium oxide, represented by (Li₃SiO₄) in the formula (1), and an eight-coordinate cubic structure composed of an alkali element and oxygen. The crystal structure of the silicate fluorescent material is a structure in which oxygen constituting the four-coordinate tetrahedral structure composed of silicate (SiO₄) and lithium oxide, represented by (Li₃SiO₄) in the formula (1), and oxygen constituting the eight-coordinate cubic structure composed of an alkali element and oxygen are shared. The silicate fluorescent material has a structure in which the cubic structure with eight-coordinated oxygen centered on an alkali element is interposed between the tetrahedral structures composed of silicate (SiO₄) and lithium oxide, represented by (Li₃SiO₄) in the formula (1). The four-coordinate tetrahedral structure composed of silicate (SiO₄) and lithium oxide has large and small gaps, and in the gaps, there is a large cubic structure represented by A¹O₈ (RbO₈ or CsO₈), centered on at least one first alkali element A¹ selected from the group consisting of Rb and Cs, having an ionic radius larger than that of K, and a small cubic structure represented by A²O₈ (KOs, NaOs, or LiOs), centered on at least one second alkali element A² selected from the group consisting of K, Na, and Li, having an ionic radius equal to or smaller than that of K.

It is presumed that Eu as the activating element of the silicate fluorescent material is replaced to the first alkali element A¹ or the second alkali element A². The silicate fluorescent material having a composition represented by the formula (1) is excited by light having a wavelength in a range of 300 nm or more and 500 nm or less, and preferably emits fluorescence having a light emission peak wavelength of 520 nm or more and 560 nm or less. It is therefore presumed that Eu as the activating element is easily replaced to the second alkali element A², which is at least one selected from the group consisting of K, Na and Li, having an ionic radius closer to that of Eu. Eu as the activating element is incorporated into the crystal structure by being replaced to the first alkali element A¹ or the second alkali element A². Among Eu as the activating element contained in the silicate fluorescent material, divalent Eu²⁺ contributes to light emission.

A silicate fluorescent material includes a large cubic structure centered on a first alkali element A¹ having an ionic radius larger than that of K, and a small cubic structure centered on a second alkali element A² having an ionic radius equal to or smaller than that of K, interposed between four-coordinate tetrahedral structures composed of silicate (SiO₄) and lithium oxide, wherein the following (i) and (ii) are shared in which (i) oxygen constituting the tetrahedral structure of silicate (SiO₄) and lithium oxide and (ii) oxygen constituting the large cubic structure and the small cubic structure. Therefore, the crystal structure is easily distorted and defects are easily generated in the crystal structure. When defects are generated in the crystal structure of the silicate fluorescent material, Eu²⁺, which is replaced to the first alkali element A¹, is likely to change to trivalent Eu³⁺ in order to achieve charge balance. When the divalent Eu²⁺ contained in the silicate fluorescent material changes to trivalent Eu³⁺, which does not contribute to light emission, the light emission intensity decreases.

The silicate fluorescent material having a composition represented by the formula (1) has a composition in which a part of the first alkali element A¹ or the second alkali element A² is replaced by a divalent or trivalent element M¹. Because a part of the first alkali element A¹ or the second alkali element A² is replaced by the divalent or trivalent element M¹, the silicate fluorescent material having a composition represented by the formula (1) does not need to change the divalent Eu²⁺ to trivalent Eu³⁺ in order to achieve charge balance, and it is possible to maintain the divalent Eu²⁺ that contributes to light emission of the silicate fluorescent material and reduce a decrease in light emission intensity.

In the silicate fluorescent material having a composition represented by the formula (1), the divalent or trivalent element M¹ to be replaced to the first alkali element A¹ is preferably an element M¹ having an ionic radius close to that of the first alkali element A¹. The divalent or trivalent element M¹ to be replaced to at least one first alkali element A¹ selected from the group consisting of Rb and Cs is preferably at least one element M¹ selected from the group consisting of Sr, Ba, Y, and La.

In the silicate fluorescent material having a composition represented by the formula (1), the divalent element M¹ to be replaced to the second alkali element A² is preferably an element M¹ having an ionic radius close to that of the second alkali element A². The divalent element M¹ to be replaced to at least one second alkali element A² selected from the group consisting of K, Na, and Li is preferably at least one element M¹ selected from the group consisting of Mg and Ca. Because the second alkali element A ² has an ionic radius smaller than that of the first alkali element A¹, the element M¹ to be replaced to the second alkali element A² is preferably not a trivalent element, but a divalent element M¹ having an ionic radius close to that of the second alkali element A².

In the silicate fluorescent material having a composition represented by the formula (1), the divalent or trivalent element M¹ to be replaced to the first alkali element A¹ or the second alkali element A² may be an element M¹ to be replaced to the first alkali element A¹, may be an element M¹ to be replaced to the second alkali element A², or may be two or more elements M¹ to be replaced to both of the first alkali element A¹ and the second alkali element A², in order to achieve charge balance. The divalent or trivalent element M¹ to be replaced to at least one of the first alkali element A¹ and the second alkali element A² is preferably at least one element M¹ selected from the group consisting of Mg, Ca, Sr, Ba, Y, and La. In the silicate fluorescent material having a composition represented by the formula (1), the element M¹, as the smaller ionic radius is easier to be replaced to the alkali element, is preferably at least one element M¹ selected from the group consisting of Mg and Ca, which is more easily replaced to the second alkali element A² having an ionic radius smaller than that of the first alkali element A¹. In the silicate fluorescent material having a composition represented by the formula (1), the element M¹ to be replaced to the second alkali element A² is preferably Mg. In the silicate fluorescent material having a composition represented by the formula (1), for example, when the second alkali element A² is Na, the divalent element M¹ to be replaced to the second alkali element A² is preferably Mg having an ionic radius close to that of Na.

In the silicate fluorescent material having a composition represented by the formula (1), the parameter w represents a molar ratio of the second alkali element A² in 1 mol of the composition represented by the formula (1). In the silicate fluorescent material, the parameter w is more than 0 and less than 1.0 (0 < w < 1.0), preferably 0.1 or more and 0.24 or less (0.1 ≤ w ≤ 0.24), and more preferably 0.12 or more and 0.23 or less (0.12 ≤ w ≤ 0.23), in the composition represented by the formula (1). When the parameter w, which represents a molar ratio of the second alkali element A² in 1 mol of the composition represented by the formula (1), is more than 0 and less than 1.0 (0 < w < 1.0), a large cubic structure centered on the first alkali element A¹ and a small cubic structure centered on the second alkali element A² are interposed between a four-coordinate tetrahedral structures composed of silicate (SiO₄) and lithium oxide, represented by (Li₃SiO₄) in the formula (1), and the silicate fluorescent material is likely to have a stable crystal structure.

In the silicate fluorescent material having a composition represented by the formula (1), the parameter x represents a molar ratio of the element M¹ in 1 mol of the composition represented by the formula (1). In the silicate fluorescent material, the parameter x is more than 0 and 0.125 or less (0 < x ≤ 0.125), preferably 0.01 or more and 0.125 or less (0.01 ≤ x ≤ 0.125), more preferably 0.02 or more and 0.125 or less (0.02 ≤ x ≤ 0.125), and even more preferably 0.02 or more and 0.10 or less (0.02 ≤ x ≤ 0.10), in the composition represented by the formula (1). When the parameter x, which represents a molar ratio of the element M¹ in 1 mol of the composition represented by the formula (1), is more than 0 and 0.125 or less (0 < x ≤ 0.125), the silicate fluorescent material does not require Eu as the activating element to change from divalent Eu²⁺ to trivalent Eu³⁺ in order to achieve charge balance, thereby maintaining divalent Eu²⁺, which contributes to light emission of the silicate fluorescent material, and reducing the decrease in light emission intensity. The sum of the parameter w, which represents a molar ratio of the second alkali element A², and the parameter x, which represents a molar ratio of the element M¹, is 1.0 or less (w+x ≤ 1.0).

In the silicate fluorescent material having a composition represented by the formula (1), the parameter y represents a molar ratio of Eu as the activating element in 1 mol of the composition represented by the formula (1). In the silicate fluorescent material, the parameter y is more than 0 and 0.08 or less (0 < y ≤ 0.08), preferably 0.01 or more and 0.08 or less (0.01 ≤ y ≤ 0.08), more preferably 0.02 or more and 0.07 or less (0.02 ≤ y ≤ 0.07), and even more preferably 0.03 or more and 0.06 or less (0.03 ≤ y ≤ 0.06), in the composition represented by the formula (1). When the parameter y, which represents a molar ratio of Eu in 1 mol of the composition represented by the formula (1), is more than 0 and 0.08 or less (0 < y ≤ 0.08), the silicate fluorescent material contains a sufficient amount of Eu in the structure to contribute to light emission.

In the silicate fluorescent material having a composition represented by the formula (1), it is preferred that the first alkali element A¹ includes Rb and the second alkali element A² includes Na in order to stabilize the crystal structure. In the large cubic structure centered on the first alkali element A¹ and the small cubic structure centered on the second alkali element A² interposed between the four-coordinated tetrahedral structures composed of silicate (SiO₄) and lithium oxide in the silicate fluorescent material, when the first alkali element A¹, which is the central element of the large cubic structure interposed between the tetrahedral structures, contains Rb, and the second alkali element A², which is the central element of the small cubic structure interposed between the tetrahedral structures, contains Na, distortion of the gaps between the tetrahedral structures and distortions of the large and small cubic structures are less likely to occur, and the crystal structure is stabilized. In the silicate fluorescent material having a composition represented by the formula (1), it is more preferred that the first alkali element A¹ is Rb and the second alkali element A² is Na in order to stabilize the crystal structure.

In the silicate fluorescent material having a composition represented by the formula (1), it is preferred that the element M¹ includes Mg. In the silicate fluorescent material having a composition represented by the formula (1), when the element M¹ includes Mg, the second alkali element A² can be replaced in advance by the divalent element M¹ in the crystal structure of the silicate fluorescent material, which is prone to defects, to reduce the change of divalent Eu²⁺, which is the activating element that contributes to light emission, into trivalent Eu³⁺, thereby maintaining the light emission intensity and improving the light resistance of the silicate fluorescent material. In the silicate fluorescent material having a composition represented by the formula (1), when the element M¹ includes Mg, the divalent Mg reduces the change of divalent Eu²⁺ into trivalent Eu³⁺ in order to achieve charge balance, and the crystal structure is easily stabilized by Mg having an ionic radius close to that of the second alkali element A², thereby suppressing defects in the crystal structure and maintaining the light emission intensity. In the silicate fluorescent material having a composition represented by the formula (1), it is more preferred that the element M¹ is Mg. In the silicate fluorescent material having a composition represented by the formula (1), when the first alkali element A¹ includes Rb and the second alkali element A² includes Na, the element M¹ may include Mg, or the element M¹ may be Mg. In the silicate fluorescent material having a composition represented by the formula (1), when the first alkali element A¹ is Rb and the second alkali element A² is Na, the element M¹ may include Mg, or the element M¹ may be Mg.

The silicate fluorescent material having a composition represented by the formula (1) preferably has a lowest possible thermoluminescence intensity (hereinafter also referred to as "TL intensity") in the range of 550 K or more in a thermoluminescence spectrum (glow curve) obtained by thermoluminescence measurement. The thermoluminescence spectrum (glow curve) of the fluorescent material obtained by thermoluminescence measurement shows light emission due to the transfer of electrons trapped in defect levels caused by defects in the crystal structure to Eu²⁺ as the light emission center, and the TL intensity is proportional to the concentration of the defect levels. The source of electrons trapped in the defect levels is considered to be due to Eu²⁺, which can also exist as Eu³⁺. In the thermoluminescence spectrum, if the TL intensity in the range of 550 K or more can be suppressed, the number of electrons trapped in the defect level can be reduced, and the decrease in light emission intensity can be reduced.

The silicate fluorescent material having a composition represented by the formula (1) preferably has a ratio TLa/TLp of 0.25 or less in the thermoluminescence spectrum (glow curve) obtained by thermoluminescence measurement, wherein the ratio TLa/TLp is a ratio of an average thermoluminescence intensity value TLa in the range of 560 K or more and 580 K or less to a maximum thermoluminescence intensity value TLp in the range of 240 K or more and 350 K or less. In the silicate fluorescent material having a composition represented by the formula (1), when the ratio TLa/TLp, which is a ratio of an average thermoluminescence intensity value TLa in the range of 560 K or more and 580 K or less to a maximum thermoluminescence intensity value TLp in the range of 240 K or more and 350 K or less, is 0.25 or less in the thermoluminescence spectrum (glow curve), the TL intensity in the range of 550K or more is suppressed, and the decrease in light emission intensity is reduced. In the silicate fluorescent material having a composition represented by the formula (1), the ratio TLa/TLp, which is a ratio of an average thermoluminescence intensity value TLa in the range of 560 K or more and 580 K or less to a maximum thermoluminescence intensity value TLp in the range of 240 K or more and 350 K or less, is more preferably 0.20 or less, even more preferably 0.15 or less, and still more preferably 0.10 or less, in the thermoluminescence spectrum.

The silicate fluorescent material having a composition represented by the formula (1) is excited by light having a wavelength in the range of 300 nm or more and 500 nm or less, and preferably emits fluorescence having a light emission peak wavelength of 520 nm or more and 560 nm or less, more preferably 520 nm or more and 550 nm or less, and even more preferably 520 nm or more and 540 nm or less.

The silicate fluorescent material may have an average particle diameter (Fisher Sub-Sieve Sizer's Number), as measured by a Fisher Sub-Sieve Sizer method (hereinafter also referred to as "FSSS method"), of 1 µm or more and 45 µm or less, may be 3 µm or more and 42 µm or less, may be 5 µm or more and 40 µm or less, or may be 10 µm or more and 35 µm or less. When the average particle diameter of the silicate fluorescent material, as measured by the FSSS method, is 1 µm or more and 45 µm or less, the silicate fluorescent material has good light emission characteristics and can be easily handled during production of light emitting devices. The FSSS method is a method of measuring a specific surface area by utilizing the flow resistance of air through an air permeability method to mainly determine a particle diameter of primary particles.

The silicate fluorescent material may also be used in a light emitting device in which fluorescent materials each emitting green, yellow, red, and deep red light are used in combination to emit white light by mixing the light emission from the excitation light source and the light emission from each fluorescent material.

The light emitting device includes the silicate fluorescent material described above, and a light emitting element capable of irradiating the silicate fluorescent material with excitation light and having a light emission peak wavelength in a range of 300 nm or more and 500 nm or less.

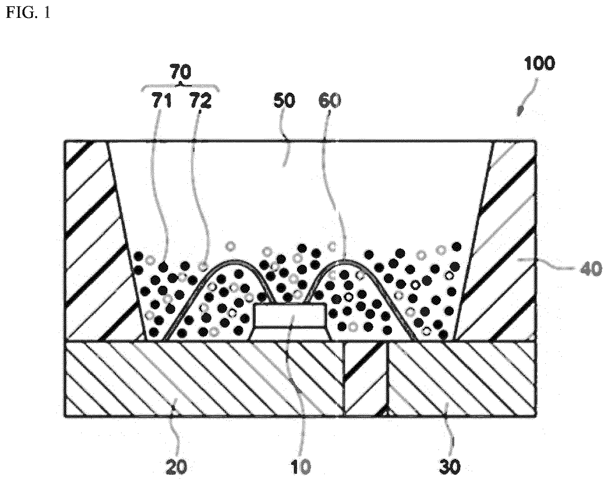

FIG. 1 shows a schematic cross-sectional view of an example light emitting device 100.

The light emitting device 100 includes a formed body 40 having a recessed portion, a light emitting element 10 disposed in the recessed portion of the formed body 40, and a wavelength conversion member 50 that covers the light emitting element 10. The formed body 40 is formed by monolithically forming a first lead 20, a second lead 30, and a resin portion containing a thermosetting resin, a thermoplastic resin, or an ultraviolet curing resin. In the formed body 40, the first lead 20 and the second lead 30 are disposed to constitute the bottom surface of the recessed portion, and the resin portion is disposed to constitute the lateral surfaces of the recessed portion. The light emitting element 10 is mounted on the bottom surface of the recessed portion of the formed body 40. The light emitting element 10 has a pair of positive and negative electrodes, and the pair of positive and negative electrodes are respectively electrically connected to the first lead 20 and the second lead 30 via a wire 60. The light emitting element 10 is covered by the wavelength conversion member 50. The wavelength conversion member 50 includes a fluorescent material 70 including a silicate fluorescent material that converts the wavelength of light emitted from the light emitting element 10 serving as an excitation light source. The fluorescent material 70 contains a first fluorescent material 71 including a silicate fluorescent material, and may contain a second fluorescent material 72 having a composition different from that of the first fluorescent material. The wavelength conversion member 50 functions not only as a wavelength conversion member, but also as a member for protecting the light emitting element 10 and the fluorescent material 70 including a silicate fluorescent material from the external environment. The light emitting device 100 emits light by receiving external electric power through the first lead 20 and the second lead 30.

A light emitting element can be used as an excitation light source for the light emitting device. The light emitting element has a light emission peak wavelength in the range of 300 nm or more and 500 nm or less, preferably 380 nm or more and 500 nm or less, more preferably 400 nm or more and 480 nm or less, even more preferably 420 nm or more and 470 nm or less, and particularly preferably 420 nm or more and 460 nm or less. The use of the light emitting element that emits light having a light emission peak wavelength in the range of 300 nm or more and 500 nm or less as an excitation light source allows the light emitting device to emit mixed-color light of the light from the light emitting element and fluorescence from fluorescent materials.

As the light emitting element, a semiconductor light emitting element using a nitride-based semiconductor (In_{X}Al_{Y}Ga_{1-X-Y}N, 0 ≤ X, 0 ≤ Y, X+Y ≤ 1) is preferably used. The use of the semiconductor light emitting element using as the excitation light source for the light emitting device enables obtaining a stable light emitting device having high efficiency, high input-output linearity, and high resistance to mechanical impacts. The light emitting element preferably has a light emission spectrum with a full width at half maximum of, for example, 30 nm or less.

The light emitting device includes the silicate fluorescent material described above. It is preferred that the silicate fluorescent material has fluorescent material particles having a composition represented by the formula (1) and emits fluorescence having a light emission peak wavelength of 520 nm or more and 560 nm or less upon irradiation with excitation light having a light emission peak wavelength in the range of 300 nm or more and 500 nm or less. The light emitting device may contain a first fluorescent material including the silicate fluorescent material and a second fluorescent material having a composition different from that of the silicate fluorescent material and emitting fluorescence having a light emission peak wavelength different from that of the first fluorescent material. The light emitting device contains the silicate fluorescent material and a fluorescent material having a light emission peak wavelength different from that of the silicate fluorescent material, thereby emitting mixed-color light having a desired color temperature and a wide range of color reproducibility or high color rendering properties.

The first fluorescent material may be contained, for example, in a wavelength conversion member that covers an excitation light source to constitute the light emitting device. In the light emitting device in which a light emitting element serving as the excitation light source is covered with a wavelength conversion member containing a first fluorescent material, a part of the light emitted from the light emitting element serving as the excitation light source is absorbed by the first fluorescent material to emit fluorescence having a light emission peak wavelength different from that of the light emitted by the light emitting element.

The content of the first fluorescent material contained in the light emitting device is not particularly limited. For example, the content of the first fluorescent material may be 1 part by mass or more and 200 parts by mass or less, preferably 2 parts by mass or more and 180 parts by mass or less, relative to the content of a resin constituting the wavelength conversion member being 100 parts by mass. The resin contained in the wavelength conversion member may be a thermosetting resin, a thermoplastic resin, or an ultraviolet curing resin. Specific examples of the resin include an acrylic resin, a carbonate resin, a sulfone resin, an epoxy resin, a urethane resin, an ester resin, a silicone resin, a styrene resin, a vinyl resin, an olefin-based resin such as a cyclic olefin resin, and a (meth)acrylate-based resin; and at least one selected from the group consisting of these may be contained. In the present specification, the (meth)acrylate-based resin refers to a resin containing a (meth)acryloyl group, and refers to a resin containing at least one selected from the group consisting of methacrylate and acrylate. The resin may preferably include at least one selected from the group consisting of an acrylic resin, a silicone resin, and an epoxy resin. The resin contained in the wavelength conversion member may be one type alone or a combination of two or more types.

The wavelength conversion member may further contain, for example, a filler and a light diffusing material in addition to the resin and the fluorescent material. For example, by containing a filler or a light diffusing material, the directivity of the light emitted from the excitation light source may be relaxed to increase the viewing angle. Examples of the filler or the light diffusing material include silica, titanium oxide, zinc oxide, zirconium oxide, and alumina. When the wavelength conversion member contains a filler or a light diffusing material, the content of the filler or the light diffusing material may be, for example, 1 part by mass or more and 20 parts by mass or less relative to the content of the resin contained in the wavelength conversion member being 100 parts by mass.

The method for producing a silicate fluorescent material includes: providing raw materials including a first compound containing at least one first alkali element A¹ selected from the group consisting of Rb and Cs, a second compound containing at least one second alkali element A² selected from the group consisting of K, Na, and Li, a third compound containing at least one element M¹ selected from the group consisting of Mg, Ca, Sr, Ba, Y, and La, a fourth compound containing Li, a fifth compound containing Si, and a sixth compound containing Eu, wherein at least one compound of the first to sixth compounds is an oxide; mixing the raw materials to obtain a raw material mixture such that the first alkali element A¹ contained in the first compound, the second alkali element A² contained in the second compound, the element M¹ contained in the third compound, Li contained in the fourth compound, Si contained in the fifth compound, and Eu contained in the sixth compound satisfy molar ratios in a composition represented by the following formula (1); and first heat-treating the raw material mixture at a first temperature in a range of 400°C or higher and 800°C or lower in a reducing atmosphere to obtain a first heat-treated product having a composition represented by the following formula (1):

A¹_{1-w-x}A²_{w}M¹ₓ(Li₃SiO₄):Eu_{y} (1)

wherein w, x, and y satisfy 0 < w < 1.0, 0 < x ≤ 0.125, w+x ≤ 1.0, and 0 < y ≤ 0.08.

The first to sixth compounds can each be an oxide, hydroxide, or carbonate containing the first alkali element A¹, the second alkali element A², the element M¹, Li, Si, and Eu, or may be a hydrate thereof. Specifically, examples of the first compound containing the first alkali element A¹ include Rb₂O, RbOH, Rb₂CO₃, and Cs₂CO₃. Examples of the second compound containing the second alkali element A² include K₂O, KOH, K₂CO₃, Na₂O, NaOH, Na₂CO₃, Li₂O, LiOH, and Li₂CO₃. Examples of the third compound containing the element M¹ include MgO, Mg(OH)₂, MgCO₃, CaO, Ca(OH)₂, CaCO₃, SrO, Sr(OH)₂, SrCO₃, BaO, Ba(OH)₂, BaCO₃, Y₂O₃, Y₂(CO₃)₃, La₂O₃, and La(OH)₃. Examples of the fourth compound containing Li include Li₂O, LiOH, and Li₂CO₃, similar to the second compound. Examples of the fifth compound containing Si include SiO₂. Examples of the sixth compound containing Eu include Eu₂O₃, Eu(OH)₂, and EuCO₃. When the second alkali element A² is Li, the second compound containing the second alkali element A ² and the fourth compound containing Li may be the same compound. When the second compound and the fourth compound are the same compound containing Li, the second compound and the fourth compound are preferably mixed such that the molar ratio of Li contained in each compound satisfies both the molar ratio of Li that is the second alkali element A² in 1 mol of the composition represented by the formula (1) and the molar ratio of Li that constitutes the composition of (Li₃SiO₄) in the formula (1) rather than the Li contained as the second alkali element A².

The first alkali element A¹ contained in the first compound, the second alkali element A² contained in the second compound, the element M¹ contained in the third compound, Li contained in the fourth compound, Si contained in the fifth compound, and Eu contained in the sixth compound are weighed so as to satisfy the molar ratios in the composition represented by the formula (1), and the first to sixth compounds are mixed to obtain a raw material mixture.

The weighed first to sixth compounds are wet or dry mixed using a mixing machine to obtain a raw material mixture. As the mixing machine, for example, a ball mill, a vibration mill, a roll mill, and a jet mill, which are industrially commonly used, can be used. The raw materials may be pulverized to increase the specific surface area in order to promote the reaction. The raw materials may be classified to ensure that the specific surface area of the particles of each compound is within a certain range. A wet separator, such as a sedimentation tank, a hydrocyclone, or a centrifugal separator, or a dry classifier, such as a cyclone or an air separator, which are commonly used in industry, may be used to classify the raw materials.

The raw material mixture may contain a flux. When the raw material mixture contains a flux, the reactions of the first to sixth compounds are promoted during the first heat treatment of the raw material mixture described below, and the solid-phase reaction proceeds uniformly, thereby obtaining a first heat-treated product that is a silicate fluorescent material having a large particle diameter and good light emission characteristics. As the flux, a halide can be used. When a halide is used as the flux, the temperature at which the liquid phase of the halide is formed is approximately equal to the temperature at which the raw material mixture is subjected to the first heat treatment described below, and the solid-phase reaction between the compounds proceeds more uniformly, thereby obtaining a first heat-treated product that is a silicate fluorescent material having a large particle diameter and good light emission characteristics. Examples of the halide used as the flux include chlorides or fluorides containing rare earth metal elements such as cerium and europium, and chlorides or fluorides containing alkali elements or alkaline earth elements. If the elements contained in the flux are elements contained in the composition of the silicate fluorescent material, the flux may be added to the raw material mixture as a part of the elements constituting the composition by adjusting the molar ratio of the elements contained in the flux to achieve the composition of the silicate fluorescent material to be obtained. Even if the elements contained in the flux are elements contained in the composition of the silicate fluorescent material core particles, the flux may be further added to the raw material mixture without taking into consideration the composition of the silicate fluorescent material core particles. When the raw material mixture contains a flux, in order to further promote the reactions of the first to sixth compounds, the amount of the flux added is preferably 10 parts by mass or less, may be 5 parts by mass or less, or may be 1 part by mass or more, relative to 100 parts by mass of the raw material mixture without the flux.

The raw material mixture can be subjected to a first heat treatment at a first temperature in the range of 400°C or higher and 800°C or lower in a reducing atmosphere to obtain a first heat-treated product having a composition represented by the formula (1). The raw material mixture can be placed in a crucible or boat container formed of materials such as silicon carbide (SiC), quartz, aluminum oxide, or boron nitride (BN), and subjected to the first heat treatment in a furnace.

The first temperature at which the first heat treatment is performed is 400°C or higher and 800°C or lower, preferably 500°C or higher and 780°C or lower, and more preferably 600°C or higher and 750°C or lower. By performing the first heat treatment at a relatively low temperature in a range of 400°C or higher and 800°C or lower, a first heat-treated product, which is a silicate fluorescent material having a composition represented by the formula (1) including a first alkali element A¹, a second alkali element A², a divalent or trivalent element M¹ instead of the first alkali element A¹ or the second alkali element A², and Eu, can be obtained.

The time for which the first heat treatment is performed is preferably 1 hour or more and 20 hours or less, more preferably 2 hours or more and 15 hours or less, and even more preferably 3 hours or more and 12 hours or less, in order to obtain a first heat-treated product, which is a silicate fluorescent material having a composition represented by the formula (1).

The atmosphere in which the first heat treatment is performed is a reducing atmosphere. The reducing atmosphere is preferably a reducing hydrogen gas-containing nitrogen atmosphere. The content of nitrogen gas in the reducing hydrogen gas-containing nitrogen atmosphere is preferably 70% by volume or more, more preferably 80% by volume or more, and even more preferably 90% by volume or more. In addition, the content of hydrogen gas in the reducing hydrogen gas-containing nitrogen atmosphere is preferably 1% by volume or more, more preferably 5% by volume or more, and even more preferably 10% by volume or more. The atmosphere in which the first heat treatment is performed may also be a reducing atmosphere using solid carbon in an air atmosphere. The raw material mixture can be calcined in a reducing atmosphere having a high reducing power to increase the content ratio of divalent Eu²⁺ in the first heat-treated product. Divalent Eu²⁺ is easily oxidized to trivalent Eu³⁺. However, by subjecting the raw material mixture to the first heat treatment in a reducing atmosphere having a high reducing power, the trivalent Eu³⁺ contained in the first heat-treated product is reduced to divalent Eu²⁺. It is therefore possible to obtain a first heat-treated product in which the content ratio of divalent Eu²⁺ contributing to light emission is increased, and to obtain a first heat-treated product that is a silicate fluorescent material having high light emission intensity.

The pressure at which the first heat treatment is performed may be standard atmospheric pressure (approximately 0.101 MPa), or may be a pressurized atmosphere of 0.101 MPa or more and 200 MPa or less, in terms of gauge pressure. By subjecting the first heat-treated product to the first heat treatment in a pressurized atmosphere, decomposition of the crystal structure can be reduced, thereby obtaining a first heat-treated product that is a silicate fluorescent material having reduced reduction in light emission intensity. The pressure in the atmosphere at which the first heat treatment is performed is preferably 0.101 MPa or more and 100 MPa or less, more preferably 0.5 MPa or more and 10 MPa or less, and from the viewpoint of ease of production, even more preferably 1.0 MPa or more and 10 MPa or less, in terms of gauge pressure.

The obtained first heat-treated product may be subjected to post-treatments after the heat treatment, such as pulverization, dispersion, solid-liquid separation, and drying. The solid-liquid separation may be performed by a method generally used industrially, such as filtration, suction filtration, pressure filtration, centrifugal separation, and decantation. The drying may be performed with an apparatus generally used industrially, such as a vacuum dryer, a hot air dryer, a conical dryer, and a rotary evaporator. After obtaining the first heat-treated product, post-treatments may be performed as necessary, and the post-treated first heat-treated product may be used as a silicate fluorescent material. After obtaining the first heat-treated product, post-treatments may be performed as necessary, and the post-treated first heat-treated product may be subjected to a second heat treatment to obtain a second heat-treated product.

The method for producing a silicate fluorescent material preferably includes second heat-treating the obtained first heat-treated product at a second temperature in a range of 200°C or higher and 350°C or lower to obtain a second heat-treated product having a composition represented by the formula (1).

The second temperature at which the second heat treatment is performed is preferably 200°C or higher and 350°C or lower, more preferably 200°C or higher and 300°C or lower. By performing the second heat treatment at a relatively low second temperature that is approximately half the first temperature of the first heat treatment, the crystal structure can be stabilized to obtain a second heat-treated product that is a silicate fluorescent material having high light emission intensity. It is presumed that by performing the second heat treating at a low temperature in the range of 200°C or higher and 350°C or lower, the large cubic structure centered on the first alkali element A¹ and the cubic structure centered on the second alkali element A², which are interposed between the four-coordinate tetrahedral structures composed of silicate (SiO₄) and lithium oxide of the silicate fluorescent material, are stabilized by the element M¹ to be replaced to the first alkali element A¹ or the second alkali element A², and are less likely to be distorted.

The second heat treatment may be performed in either an oxygen-containing atmosphere, a nitrogen-containing atmosphere, or a rare gas-containing atmosphere. The atmosphere in which the second heat treatment is performed may be an air atmosphere (oxygen content of 20% by volume or more), a nitrogen atmosphere (100% by volume of nitrogen), or a rare gas-containing atmosphere (e.g. 100% by volume of argon (Ar)).

The time for which the second heat treatment is performed may be, for example, 0.5 hours or more and 20 hours or less, may be 1 hour or more and 15 hours or less, or may be 2 hours or more and 12 hours or less. The duration time of 0.5 hours or more and 20 hours or less allows the crystal structure to be more stabilized.

The pressure at which the second heat treatment is performed may be standard atmospheric pressure (approximately 0.101 MPa), or may be a pressurized atmosphere of 0.101 MPa or more and 100 MPa or less. By performing the second heat treatment in a pressurized atmosphere of 0.101 MPa or more and 100 MPa or less, the crystal structure can be stabilized. The pressure in the atmosphere at which the second heat treatment is performed is preferably 0.101 MPa or more and 100 MPa or less, more preferably 0.5 MPa or more and 10 MPa or less, and from the viewpoint of ease of production, even more preferably 1.0 MPa or more and 10 MPa or less, in terms of gauge pressure.

### EXAMPLES

The present disclosure is hereunder specifically described with reference to the following Examples. However, the present disclosure is not limited to these Examples.

The silicate fluorescent materials according to Examples and Comparative Examples described below were subjected to the following evaluations. The results of the evaluations, as well as the molar ratios in the preparation compositions of the silicate fluorescent materials according to Examples and Comparative Examples described below, are shown in Tables 1 and 2. In Table 1, the symbol "-" indicates that there is no numerical value for the corresponding item. The silicate fluorescent materials according to Examples 1 to 11 described below each have a composition represented by the formula (1).

### Light Emission Characteristics (Relative Light Emission Intensity, Light Emission Peak Wavelength λp, and Full Width at Half Maximum (FWHM))

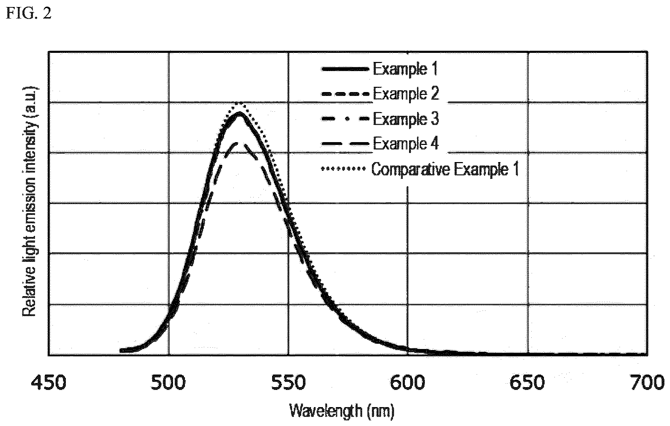

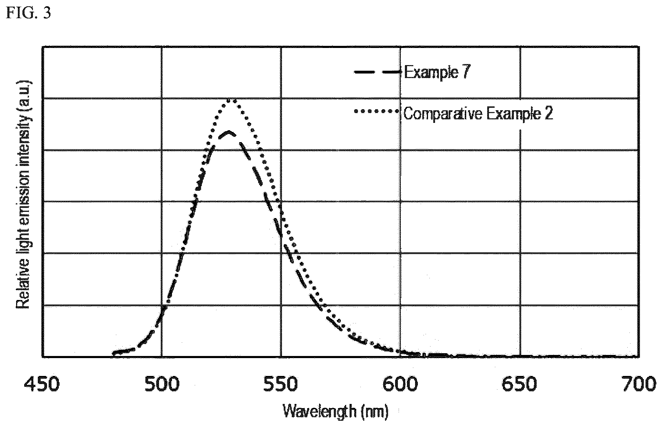

The silicate fluorescent materials according to Examples and Comparative Examples were each irradiated with excitation light having a light emission peak wavelength of 450 nm to measure the light emission spectrum at room temperature (25°C ± 5°C) using a spectrofluorometer (F-4500, manufactured by Hitachi High-Tech Science Corp.). The light emission peak wavelength λp (nm), the full width at half maximum (FWHM) (nm), and the light emission intensity at the light emission peak wavelength were measured in the light emission spectrum of each fluorescent material. The light emission intensity of each silicate fluorescent material was expressed as a relative light emission intensity, relative to the light emission intensity at the light emission peak wavelength of a β-SiAlON fluorescent material having a composition represented by the formula Si_{6-z}Al_{z}O_{z}N_{8-z}:Eu_{y1} (wherein y1 and z satisfy 0 < y1 ≤ 1.0 and 0 < z ≤ 4.2) with a light emission peak wavelength of 529 nm, being 100%. FIG. 2 shows the light emission spectra of the silicate fluorescent materials according to Examples 1 to 4 and Comparative Example 1. FIG. 3 shows the light emission spectra of the silicate fluorescent materials according to Example 7 and Comparative Example 2.

### Samples for Light Resistance Evaluation

A resin composition was prepared by mixing 50 parts by mass of each of the silicate fluorescent materials according to Examples and Comparative Examples with 100 parts by mass of an acrylic resin. The resin composition was formed into a sheet, and a barrier film having a thickness of 100 µm and a water vapor transmission rate of 0.02 g/m²·day at 40°C and a relative humidity that is 90% was placed on the top and bottom of the resin composition sheet, respectively, to sandwich the sheet. The sheet was irradiated with ultraviolet light at room temperature to UV-cure the resin of the sheet, thereby obtaining a sheet-shaped wavelength conversion member having a thickness of 70 µm and containing each of the silicate fluorescent materials according to Examples and Comparative Examples, which was used as a sample for evaluating light resistance. The wavelength conversion member was sandwiched between the two barrier films, and the total thickness of the two barrier films and the wavelength conversion member was 270 µm.

### Light Resistance Evaluation

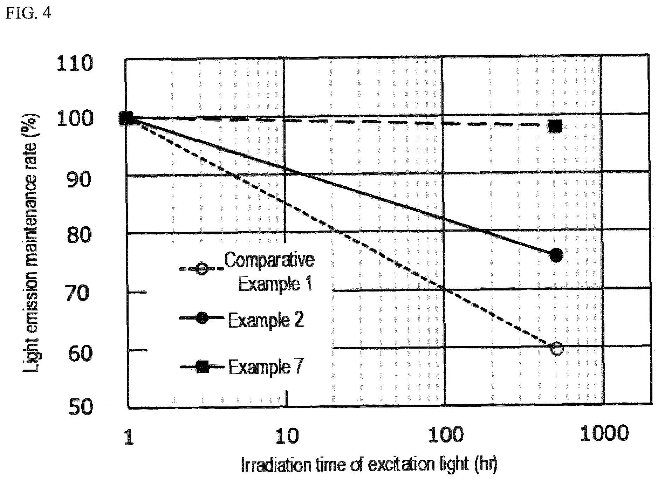

Each of the resulting samples was placed in a location to be irradiated with excitation light having a light emission peak wavelength of 450 nm and an output of 36 mW/cm² emitted by a light emitting element (LED) at room temperature (25°C), and each sample was left irradiated with the excitation light emitted by the light emitting element for 500 hours, after which the light emission spectrum of each sample after the lapse of 500 hours was measured, and the light emission intensity at the light emission peak wavelength was measured. The light emission spectrum of each sample when irradiated with the excitation light emitted by the light emitting element before the lapse of 500 hours was measured, and the ratio of the light emission intensity at the light emission peak wavelength of each sample after 500 hours of continuous irradiation with the excitation light, relative to the light emission intensity at the light emission peak wavelength before the lapse of 500 hours being 100%, was expressed as a light emission maintenance rate (%). FIG. 4 is a graph showing the relationship between the irradiation time of the excitation light and the light emission maintenance rate for the silicate fluorescent materials according to Examples 2 and 7 and Comparative Example 1.

### Example 1

Raw materials of first to sixth compounds were provided, including Rb₂CO₃ as a first compound containing a first alkali element A¹, Na₂CO₃ as a second compound containing Na, which is a second alkali element A², MgO as a third compound containing an element M¹, Li₂CO₃ as a fourth compound containing Li, SiO₂ as a fifth compound containing Si, and Eu₂O₃ as a sixth compound containing Eu.

The first to sixth compounds were weighed such that the molar ratio of each element in the preparation composition was Rb : Na : Mg : Li : Si : Eu = 0.75 : 0.23 : 0.02 : 3 : 1 : 0.04, and mixed to obtain a raw material mixture. In the raw material mixture, the molar ratios of the elements contained in the first to sixth compounds satisfy the molar ratios in the composition represented by the formula (1).

The raw material mixture was supplied into a container formed of aluminum oxide and subjected to a first heat treatment at a first heat treatment temperature that is 750°C for 10 hours in a reducing atmosphere of a mixed gas of nitrogen and hydrogen (nitrogen : hydrogen volume ratio of 70 : 30) to obtain a first heat-treated product. The first heat-treated product was subjected to post-treatments including pulverization, dispersion, solid-liquid separation, and drying.

For pulverization, wet pulverization was performed by placing the first heat-treated product and alumina balls in a solvent (ethanol). The pulverized first heat-treated product in an amount of 100 parts by mass was added to 440 parts by mass of ethanol and, while stirring using a stirrer, a 7% by mass hydrochloric acid aqueous solution in an amount of 100 parts by mass was added dropwise thereto over 30 minutes. After the hydrochloric acid aqueous solution was added dropwise, the mixture of the first heat-treated product, ethanol, and the hydrochloric acid aqueous solution was stirred for 30 minutes to disperse the mixture. The first heat-treated product was then subjected to solid-liquid separation, washed with ethanol, and dried for two days in a nitrogen atmosphere (N₂: 100% by volume) at 25°C, and the resulting first heat-treated product that was subjected to post-treatments of pulverization, dispersion, solid-liquid separation, and drying was used as a silicate fluorescent material according to Example 1.

### Example 2

A first heat-treated product was obtained in the same or similar manner as in Example 1 by using a raw material mixture obtained by using the same as or similar to the first to sixth compounds as in Example 1, except that weighing and mixing the first to sixth compounds such that the molar ratio of each element in the preparation composition was Rb : Na : Mg : Li : Si : Eu = 0.75 : 0.21 : 0.04 : 3 : 1 : 0.04, was used; and the resulting first heat-treated product was used as a silicate fluorescent material according to Example 2.

### Example 3

A first heat-treated product was obtained in the same or similar manner as in Example 1 by using a raw material mixture obtained by using the same as or similar to the first to sixth compounds as in Example 1, except that weighing and mixing the first to sixth compounds such that the molar ratio of each element in the preparation composition was Rb : Na : Mg : Li : Si : Eu = 0.75 : 0.17 : 0.08 : 3 : 1 : 0.04, was used; and the resulting first heat-treated product was used as a silicate fluorescent material according to Example 3.

### Example 4

A first heat-treated product was obtained in the same or similar manner as in Example 1 by using a raw material mixture obtained by using the same as or similar to the first to sixth compounds as in Example 1, except that weighing and mixing the first to sixth compounds such that the molar ratio of each element in the preparation composition was Rb : Na : Mg : Li : Si : Eu = 0.75 : 0.125 : 0.125 : 3 : 1 : 0.04, was used; and the resulting first heat-treated product was used as a silicate fluorescent material according to Example 4.

### Comparative Example 1

A first heat-treated product was obtained in the same or similar manner as in Example 1, except that a raw material mixture obtained by not using the third compound containing an element M¹, using the same or similar first, second, and fourth to sixth compounds as in Example 1, and weighing and mixing the first, second, and fourth to sixth compounds such that the molar ratio of each element in the preparation composition was Rb : Na : Mg : Li : Si : Eu = 0.75 : 0.25 : 0 : 3 : 1 : 0.04, was used; and the resulting first heat-treated product was used as a silicate fluorescent material according to Comparative Example 1.

**Table 1**

| | Molar ratios in Target composition | | | | | | Light emission characteristics | | | Light resistance |
|---|---|---|---|---|---|---|---|---|---|---|
| | Rb | Na | Mg | Li | Si | Eu | Relative light emission intensity (%) | Light emission peak wavelength λp (nm) | Full width at half maximum FWHM (nm) | Light emission maintenance rate (%) |
| Example 1 | 0.75 | 0.23 | 0.02 | 3 | 1 | 0.04 | 122.8 | 530 | 422 | 723 |
| Example 2 | | 0.21 | 0.04 | | | | 122.5 | 530 | 421 | 75.7 |
| Example 3 | | 0.17 | 0.08 | | | | 121.7 | 530 | 41.9 | 85.1 |
| Example 4 | | 0.125 | 0.125 | | | | 107.5 | 530 | 422 | 86.9 |
| Comparative Example 1 | | 0.25 | - | | | | 128.8 | 530 | 423 | 59.2 |
| β-SiAlON fluorescent material | - | - | - | - | - | - | 100.0 | 529 | 51.2 | - |

The silicate fluorescent materials according to Examples 1 to 4 each emitted, upon irradiation with excitation light emitted by the light emitting element having a light emission peak wavelength of 450 nm, green fluorescence having a light emission peak wavelength λp of 530 nm, which is within the range of 520 nm or more and 560 nm or less. The silicate fluorescent materials according to Examples 1 to 4 each had a sharp light emission peak with a narrower full width at half maximum in the light emission spectrum than that of the β-SiAlON fluorescent material emitting green fluorescence having a light emission peak wavelength of 529 nm. As shown in FIG. 2, the silicate fluorescent materials according to Examples 1 to 3 had light emission peaks that substantially overlapped with each other in the light emission spectrum.

The silicate fluorescent materials according to Examples 1 to 4 each had a composition represented by the formula (1) in which the element M¹ was included in the composition and a part of the first alkali element A¹ or the second alkali element A² was replaced by Mg being the divalent element M¹. The silicate fluorescent materials according to Examples 1 to 4 each reduced the change of divalent Eu²⁺, which contributes to light emission, to trivalent Eu³⁺ in order to achieve charge balance, and even after being continuously irradiated with excitation light having an output of 36 mW/cm² for 500 hours, the silicate fluorescent materials had a light emission maintenance rate of more than 60%, and the decrease in light emission intensity was reduced.

The silicate fluorescent material according to Comparative Example 1 had a slightly higher relative light emission intensity than that of the silicate fluorescent materials according to Examples 1 to 4, because the element M¹ was not included in the composition of the silicate fluorescent material. However, the silicate fluorescent material according to Comparative Example 1, because the element M¹ was not included in the composition of the silicate fluorescent material, did not reduce the change of divalent Eu²⁺, which contributes to light emission, to trivalent Eu³⁺, and the light emission maintenance rate was reduced to less than 60% after being continuously irradiated with excitation light having an output of 36 mW/cm² for 500 hours.

### Example 5

A first heat-treated product was obtained in the same or similar manner as in Example 1 including the use of the same or similar first, second, and fourth to sixth compounds as in Example 1, except that a raw material mixture obtained by using CaCO₃ as the third compound containing an element M¹, and weighing and mixing the first to sixth compounds such that the molar ratio of each element in the preparation composition was Rb : Na : Ca : Li : Si : Eu = 0.75 : 0.23 : 0.02 : 3 : 1 : 0.04, was used; and the resulting first heat-treated product was used as a silicate fluorescent material according to Example 5.

### Example 6

A first heat-treated product was obtained in the same or similar manner as in Example 1 including the use of the same or similar first, second, and fourth to sixth compounds as in Example 1, except that a raw material mixture obtained by using La₂O₃ as the third compound containing an element M¹, and weighing and mixing the first to sixth compounds such that the molar ratio of each element in the preparation composition was Rb : Na : La : Li : Si : Eu = 0.75 : 0.23 : 0.02 : 3 : 1 : 0.04, was used; and the resulting first heat-treated product was used as a silicate fluorescent material according to Example 6.

### Example 7

The same or similar first to sixth compounds as in Example 1 were weighed and mixed such that the molar ratio of each element in the preparation composition was Rb : Na : Mg : Li : Si : Eu = 0.75 : 0.21 : 0.04 : 3 : 1 : 0.04 to obtain a raw material mixture, and the raw material mixture was used to obtain a first heat-treated product in the same or similar manner as in Example 1. The resulting first heat-treated product was subjected to a second heat treatment at 300°C for 10 hours in a nitrogen atmosphere (N₂: 100% by volume) to obtain a second heat-treated product, and the second heat-treated product was used as a silicate fluorescent material according to Example 7.

### Example 8

The same or similar first to sixth compounds as in Example 1 were weighed and mixed such that the molar ratio of each element in the preparation composition was Rb : Na : Mg : Li : Si : Eu = 0.75 : 0.21 : 0.04 : 3 : 1 : 0.04 to obtain a raw material mixture, and the raw material mixture was used to obtain a first heat-treated product in a manner same as or similar to that in Example 1. The resulting first heat-treated product was subjected to a second heat treatment at 250°C for 10 hours in a nitrogen atmosphere (N₂: 100% by volume) to obtain a second heat-treated product, and the second heat-treated product was used as a silicate fluorescent material according to Example 8.

### Example 9

The same or similar first to sixth compounds as in Example 1 were weighed and mixed such that the molar ratio of each element in the preparation composition was Rb : Na : Mg : Li : Si : Eu = 0.75 : 0.21 : 0.04 : 3 : 1 : 0.04 to obtain a raw material mixture, and the raw material mixture was used to obtain a first heat-treated product in a manner same as or similar to that in Example 1. The resulting first heat-treated product was subjected to a second heat treatment at 200°C for 10 hours in a nitrogen atmosphere (N₂: 100% by volume) to obtain a second heat-treated product, and the second heat-treated product was used as a silicate fluorescent material according to Example 9.

### Example 10

The same or similar first to sixth compounds as in Example 1 were weighed and mixed such that the molar ratio of each element in the preparation composition was Rb : Na : Mg : Li : Si : Eu = 0.75 : 0.17 : 0.08 : 3 : 1 : 0.02 to obtain a raw material mixture, and the raw material mixture was used to obtain a first heat-treated product in the same or similar manner as in Example 1. The resulting first heat-treated product was subjected to a second heat treatment at 250°C for 10 hours in a nitrogen atmosphere (N₂: 100% by volume) to obtain a second heat-treated product, and the second heat-treated product was used as a silicate fluorescent material according to Example 10.

### Example 11

The same or similar first to sixth compounds as in Example 1 were weighed and mixed such that the molar ratio of each element in the preparation composition was Rb : Na : Mg : Li : Si : Eu = 0.75 : 0.17 : 0.08 : 3 : 1 : 0.01 to obtain a raw material mixture, and the raw material mixture was used to obtain a first heat-treated product in the same or similar manner as in Example 1. The resulting first heat-treated product was subjected to a second heat treatment at 250°C for 10 hours in a nitrogen atmosphere (N₂: 100% by volume) to obtain a second heat-treated product, and the second heat-treated product was used as a silicate fluorescent material according to Example 11.

### Comparative Example 2

The first heat-treated product obtained in Comparative Example 1 was subjected to a second heat treatment at 150°C for 10 hours in a nitrogen atmosphere (N₂: 100% by volume) to obtain a second heat-treated product, and the second heat-treated product was used as a silicate fluorescent material according to Comparative Example 2.

**Table 2**

| | Molar ratios in Target composition | | | | | | | | Second heat treatment temperature (°C) | Light emission characteristics | | Light resistance |
|---|---|---|---|---|---|---|---|---|---|---|---|---|
| | Rb | Na | Mg | Ca | La | Li | Si | Eu | | Light emission peak wavelength λp (nm) | Full width at half maximum FWHM (nm) | Light emission maintenance rate (%) |
| Example 5 | | 0.23 | - | 0.02 | - | | | 0.04 | - | 530 | 422 | 626 |
| Example 6 | | 0.23 | - | - | 0.02 | | | | - | 528 | 4.2.9 | 72.6 |
| Example 7 | | 0.21 | 0.04 | - | - | | | | 300 | 529 | 426 | 98.1 |
| Example 8 | 0.75 | 0.21 | 0.04 | - | - | 3 | 1 | | 250 | 528 | 421 | 95.5 |
| Example 9 | | 0.21 | 0.04 | - | - | | | | 200 | 528 | 41.6 | 93.0 |
| Example 10 | | 0.17 | 0.08 | - | - | | | 0.02 | 250 | 528 | 421 | 97.4 |
| Example 11 | | 0.17 | 0.08 | - | - | | | 0.01 | 250 | 527 | 42.5 | 96.7 |
| Comparative Example 2 | | 0.25 | - | - | - | | | 0.04 | 150 | 529 | 41.8 | 34.4 |

The silicate fluorescent materials according to Examples 5 to 11 each emitted, upon irradiation with excitation light emitted by the light emitting element having a light emission peak wavelength of 450 nm, green fluorescence having a light emission peak wavelength λp of 527 to 530 nm, which is within the range of 520 nm or more and 560 nm or less. The silicate fluorescent materials according to Examples 5 to 11 each had, even when subjected to the second heat treatment, a sharp light emission peak with a narrower full width at half maximum in the light emission spectrum than that of the β-SiAlON fluorescent material emitting green fluorescence having a light emission peak wavelength of 529 nm shown in Table 1. The silicate fluorescent materials according to Examples can provide a wider range of color reproducibility when used in a light emitting device for backlights.

As shown in FIG. 3, the silicate fluorescent material according to Example 7 obtained by the second heat treatment, upon irradiation with excitation light emitted by the light emitting element having a light emission peak wavelength of 450 nm, had a light emission peak wavelength of 520 nm or more and 560 nm or less.

The silicate fluorescent materials according to Examples 5 to 11 each had a composition represented by the formula (1) in which the element M¹ was included in the composition and a part of the first alkali element A¹ or the second alkali element A² was replaced by the divalent or trivalent element M¹. The silicate fluorescent materials according to Examples 5 to 11 could each reduce the change of divalent Eu²⁺, which contributes to light emission, to trivalent Eu³⁺ in order to achieve charge balance, and even after being continuously irradiated with excitation light having an output of 36 mW/cm² for 500 hours, the silicate fluorescent materials had a light emission maintenance rate of more than 60%, and the decrease in light emission intensity was reduced. The silicate fluorescent materials according to Examples 7 to 11, because they were subjected to the second heat treatment at 200°C or higher and 350°C or lower, each had a light emission maintenance rate of more than 90% even after being continuously irradiated with excitation light having an output of 36 mW/cm² for 500 hours, resulting in very good light resistance. This is presumably because, by performing the second heat treatment at 200°C or higher and 350°C or lower in the silicate fluorescent materials according to Examples 7 to 11, the crystal structure of each silicate fluorescent material in which a part of the first alkali element A¹ or the second alkali element A² is replaced by the divalent or trivalent element M¹ becomes more stable so that the change of divalent Eu²⁺, which contributes to light emission, to trivalent Eu³⁺ can be more reduced, and the decrease in light emission intensity is more reduced, resulting in a high light emission maintenance rate. The silicate fluorescent materials according to Examples 10 and 11 each had a light emission maintenance rate of more than 90% and good light resistance even though the molar ratio of Eu as the activating element in the composition represented by the formula (1) was lower than that of, for example, the silicate fluorescent material according to Example 3 shown in Table 1 above.

The silicate fluorescent material according to Comparative Example 2, because the element M¹ was not included in the composition of the silicate fluorescent material and the temperature of the second heat treatment was 150°C, which was low at lower than 200°C, did not reduce the change of divalent Eu²⁺, which contributes to light emission, to trivalent Eu³⁺, and the light emission maintenance rate was reduced to 34.4% after being continuously irradiated with excitation light having an output of 36 mW/cm² for 500 hours.

FIG. 4 is a graph showing the relationship between the irradiation time of the excitation light and the light emission maintenance rate for the silicate fluorescent materials according to Examples 2 and 7 and Comparative Example 1. As shown in FIG. 4, the silicate fluorescent materials according to Examples 2 and 7, which had a composition represented by the formula (1) in which the element M¹ was included in the composition and a part of the first alkali element A¹ or the second alkali element A² was replaced by the divalent or trivalent element M¹, each reduced the change of divalent Eu²⁺, which contributes to light emission, to trivalent Eu³⁺ in order to achieve charge balance, and even after being continuously irradiated with the excitation light for 500 hours, the silicate fluorescent materials had a high light emission maintenance rate of 70% or more, resulting in good light resistance. The silicate fluorescent material according to Example 7, which was subjected to the second heat treatment, had a very high light emission maintenance rate of 98% or more even after being continuously irradiated with the excitation light for 500 hours, resulting in very good light resistance.

The silicate fluorescent materials according to Examples 3 and 7 and Comparative Example 1 were subjected to the following measurement of thermoluminescence spectra. Table 3 shows a ratio TLa/TLp of an average thermoluminescence intensity value TLa in the range of 560 K or more and 580 K or less to a maximum thermoluminescence intensity value TLp in a range of 240 K or more and 350 K or less in a thermoluminescence spectrum obtained by measuring thermoluminescence intensity of each of the silicate fluorescent materials according to Examples 3 and 7 and Comparative Example 1.

### Thermoluminescence Spectrum

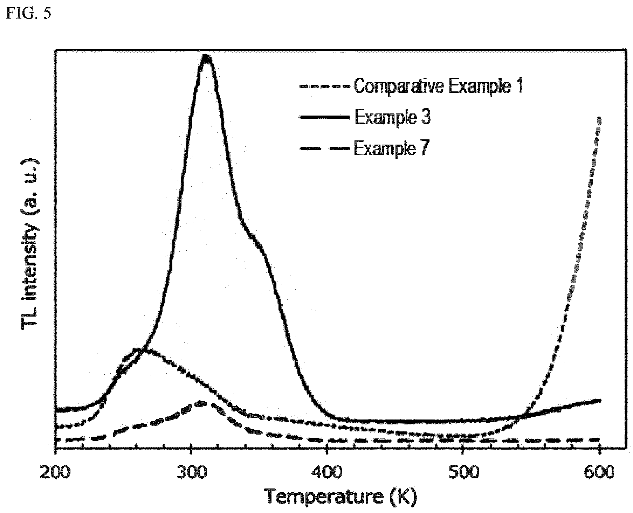

The silicate fluorescent materials according to Examples and Comparative Examples were each irradiated with excitation light from a xenon lamp light source through a bandpass filter (313 nm, full width at half maximum of 40 nm) at a temperature that is 200 K for 5 minutes, then the excitation light was shut off, a photomultiplier tube through a bandpass filter (550 nm, full width at half maximum of 40 nm) was used as a detector, and the thermoluminescence spectrum was measured by recording the change in light emission intensity while increasing the temperature. In order to release pre-trapped electrons, the measurement was performed after heating up to 600 K prior to measurement. The measurement was performed at a temperature rise rate of 30 K/min. FIG. 5 shows thermoluminescence spectra of the silicate fluorescent materials according to Examples 3 and 7 and Comparative Example 1, measured at a temperature rise rate of 30 K/min.

**Table 3**

| | Maximum TL intensity at 240 - 350 K TLp | Maximum TL intensity at 240- 350 K (K) | Average TL intensity at 560-580 K TLa | Ratio TLa / TLp |
|---|---|---|---|---|
| Example 3 | 0.012 | 306 | 0.0021 | 0.18 |
| Example 7 | 0.099 | 312 | 0.010 | 0.10 |
| Comparative Example 1 | 0.025 | 261 | 0.027 | 1.08 |

In the silicate fluorescent materials according to Examples 3 and 7, the ratio TLa/TLp of the average TL intensity value TLa in the range of 560 K or more and 580 K or less to the maximum TL intensity value TLp in the range of 240 K or more and 350 K or less was 0.25 or less in the thermoluminescence spectrum (glow curve) obtained by the thermoluminescence measurement, the TL intensity in the range of 550 K or more was suppressed, the light emission maintenance rate after continuous excitation light irradiation was high at more than 60%, and the decrease in light emission intensity was reduced.

As shown in FIG. 5, in the silicate fluorescent materials according to Examples 3 and 7, the TL intensity in the range of 550 K or more was reduced in the thermoluminescence spectrum (glow curve) obtained by the thermoluminescence measurement, indicating that there were few defects trapping electrons in the crystal structure, and electrons were less likely to be trapped in defect levels, so that electrons were less likely to be supplied to Eu²⁺ and less likely to change to Eu³⁺, thereby reducing the decrease in light emission intensity even after continuous excitation light irradiation.

In the silicate fluorescent material according to Comparative Example 1, because the element M¹ was not included in the composition of the silicate fluorescent material, the ratio TLa/TLp of the average TL intensity value TLa in the range of 560 K or more and 580 K or less to the maximum TL intensity value TLp in the range of 240 K or more and 350 K or less was 1.08, which is more than 0.25, in the thermoluminescence spectrum (glow curve) obtained by the thermoluminescence measurement. The silicate fluorescent material according to Comparative Example 1, because the TL intensity in the range of 550 K or more was high, had a light emission maintenance rate of less than 60% after continuous excitation light irradiation, resulting in low light emission intensity.

As shown in FIG. 5, in the silicate fluorescent material according to Comparative Example 1, the TL intensity in the range of 550 K or more was very high above 520 K in the thermoluminescence spectrum (glow curve) obtained by the thermoluminescence measurement, indicating that there were many defects trapping electrons in the crystal structure, and electrons trapped in the defect levels were likely to be supplied to Eu²⁺ and changed to Eu³⁺, thereby decreasing the light emission intensity after continuous excitation light irradiation.

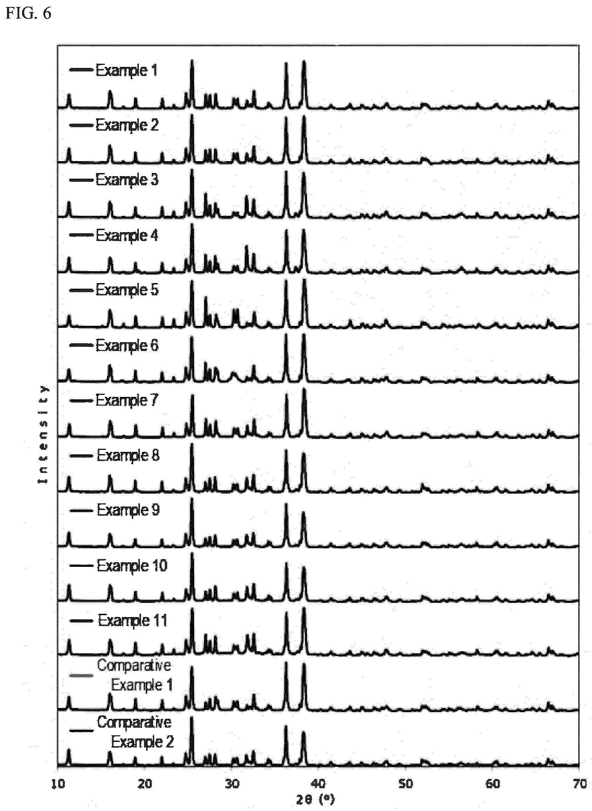

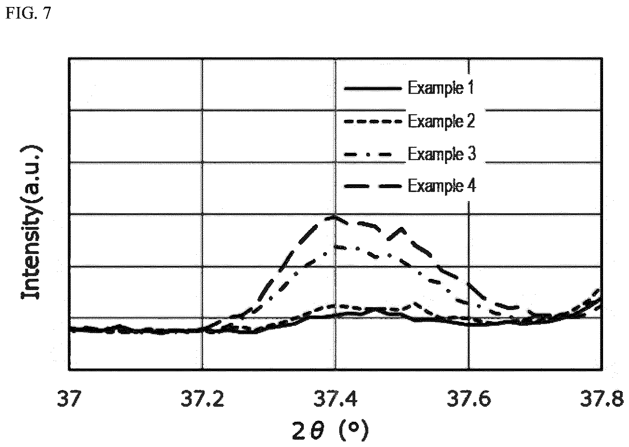

The silicate fluorescent materials according to Examples 1 to 11 and Comparative Examples 1 and 2 were subjected to the following measurements of X-ray diffraction patterns. FIG. 6 shows X-ray diffraction patterns of the silicate fluorescent materials according to Examples and Comparative Examples. FIG. 7 shows X-ray diffraction patterns of the silicate fluorescent materials according to Examples 1 to 4, with the diffraction angle 20 (°) from 37° to 37.8° enlarged.

### X-Ray Diffraction Pattern

For the silicate fluorescent materials according to Examples and Comparative Examples, the X-ray diffraction pattern was measured using a horizontal sample type multipurpose X-ray diffraction system (Ultima IV, manufactured by Rigaku Corp.) with an X-ray source of CuKα rays (λ = 1.5418 Å, tube voltage of 40 kV, and tube current of 40 mA).

In the X-ray diffraction patterns shown in FIG. 6, the silicate fluorescent materials according to Examples 1 to 11 and Comparative Examples 1 and 2 each had peaks at almost the same diffraction angle 20 (°), indicating that the crystal structure was not significantly changed even when a part of the first alkali element A¹ or the second alkali element A² was replaced by the divalent or trivalent element M¹ in the composition represented by the formula (1).

In the partially enlarged X-ray diffraction patterns of the silicate fluorescent materials according to Examples 1 to 4 shown in FIG. 7, a small peak was observed at a diffraction angle 20 (°) of 37.4° with increasing the molar ratio of the element M¹ in the preparation composition. In the silicate fluorescent materials having a composition represented by the formula (1), it is presumed that the crystal structure changes slightly as the molar ratio of the element M¹ increases.

The embodiments according to the present disclosure include the following silicate fluorescent material, light emitting device, and method for producing a silicate fluorescent material.

The silicate fluorescent material according to the present disclosure can be used as a fluorescent material contained in a wavelength conversion member of a light emitting device, and the light emitting device containing the silicate fluorescent material can be suitably used as a light emitting device used in various applications such as illumination light sources, LED displays, backlight sources for liquid crystal displays, traffic signals, illumination switches, light sources for projectors, various sensors, and various indicators.

## Claims

1. A silicate fluorescent material having a composition represented by the following formula (1):
A¹_{1-w-x}A²_{w}M¹ₓ(Li₃SiO₄):Eu_{y} (1)
wherein A¹ represents at least one first alkali element selected from the group consisting of Rb and Cs, A² represents at least one second alkali element selected from the group consisting of K, Na, and Li, M¹ represents at least one element selected from the group consisting of Mg, Ca, Sr, Ba, Y, and La, and w, x, and y satisfy 0 < w < 1.0, 0 < x ≤ 0.125, w+x ≤ 1.0, and 0 < y ≤ 0.08.

2. The silicate fluorescent material according to claim 1, wherein in the formula (1), w, x, and y satisfy 0.1 ≤ w ≤ 0.24, 0.01 ≤ x ≤ 0.125, and 0.01 ≤ y ≤ 0.08.

3. The silicate fluorescent material according to claim 1 or 2, wherein in the formula (1), x satisfies 0.02 ≤ x ≤ 0.125.

4. The silicate fluorescent material according to any one of claims 1 to 3, wherein in the formula (1), A¹ comprises Rb, and A² comprises Na.

5. The silicate fluorescent material according to claim 1, wherein in the formula (1), A¹ is Rb, and A² is Na.

6. The silicate fluorescent material according to any one of claims 1 to 5, wherein in the formula (1), M¹ comprises Mg.

7. The silicate fluorescent material according to claim 1, wherein in the formula (1), M¹ is Mg.

8. The silicate fluorescent material according to any one of claims 1 to 7, wherein in a thermoluminescence spectrum obtained by measuring thermoluminescence intensity, a ratio TLa/TLp of an average thermoluminescence intensity value TLa in a range of 560 K or more and 580 K or less to a maximum thermoluminescence intensity value TLp in a range of 240 K or more and 350 K or less is 0.25 or less.

9. A light emitting device comprising:
the silicate fluorescent material according to any one of claims 1 to 8; and
a light emitting element irradiating the silicate fluorescent material with excitation light and having a light emission peak wavelength in a range of 300 nm or more and 500 nm or less.

10. A method for producing a silicate fluorescent material, comprising:
mixing raw materials including a first compound containing at least one first alkali element A¹ selected from the group consisting of Rb and Cs, a second compound containing at least one second alkali element A² selected from the group consisting of K, Na, and Li, a third compound containing at least one element M¹ selected from the group consisting of Mg, Ca, Sr, Ba, Y, and La, a fourth compound containing Li, a fifth compound containing Si, and a sixth compound containing Eu, wherein at least one compound of the first compound to the sixth compound is an oxide, to obtain a raw material mixture,
wherein the first alkali element A¹ contained in the first compound, the second alkali element A² contained in the second compound, the element M¹ contained in the third compound, Li contained in the fourth compound, Si contained in the fifth compound, and Eu contained in the sixth compound satisfy molar ratios in a composition represented by the following formula (1); and
first heat-treating the raw material mixture at a first temperature in a range of 400°C or higher and 800°C or lower in a reducing atmosphere to obtain a first heat-treated product having the composition represented by the following formula (1):
A¹_{1-w-x}A²_{w}M¹ₓ(Li₃SiO₄):Eu_{y} (1)
wherein w, x, and y satisfy 0 < w < 1.0, 0 < x ≤ 0.125, w+x ≤ 1.0, and 0 < y ≤ 0.08.

11. The method for producing a silicate fluorescent material according to claim 10, further comprising second heat-treating the first heat-treated product at a second temperature in a range of 200°C or higher and 350°C or lower to obtain a second heat-treated product having a composition represented by the formula (1).

## Patentansprüche

1. Ein fluoreszierendes Silikatmaterial mit einer Zusammensetzung, dargestellt durch die nachstehende Formel (1):
A¹_{1-w-x}A²_{w}M¹ₓ(Li₃SiO₄):Eu_{y} (1)
wobei A¹ mindestens ein erstes Alkalielement darstellt, ausgewählt aus der Gruppe bestehend aus Rb und Cs, A² mindestens ein zweites Alkalielement darstellt, ausgewählt aus der Gruppe bestehend aus K, Na und Li, M¹ mindestens ein Element darstellt, ausgewählt aus der Gruppe bestehend aus Mg, Ca, Sr, Ba, Y und La, und w, x und y die Bedingungen 0 < w < 1,0, 0 < x ≤ 0,125, w+x ≤ 1,0 und 0 < y ≤ 0,08 erfüllen.

2. Das fluoreszierende Silikatmaterial gemäß Anspruch 1, wobei in der Formel (1) w, x und y die Bedingungen 0,1 ≤ w ≤ 0,24, 0,01 ≤ x ≤ 0,125 und 0,01 ≤ y ≤ 0,08 erfüllen.

3. Das fluoreszierende Silikatmaterial gemäß Anspruch 1 oder 2, wobei in der Formel (1) x die Bedingung 0,02 ≤ x ≤ 0,125 erfüllt.

4. Das fluoreszierende Silikatmaterial gemäß einem der Ansprüche 1 bis 3, wobei in der Formel (1) A¹ Rb umfasst und A² Na umfasst.

5. Das fluoreszierende Silikatmaterial gemäß Anspruch 1, wobei in der Formel (1) A¹ für Rb steht und A² für Na steht.

6. Das fluoreszierende Silikatmaterial gemäß einem der Ansprüche 1 bis 5, wobei in der Formel (1) M¹ Mg umfasst.

7. Das fluoreszierende Silikatmaterial gemäß Anspruch 1, wobei in der Formel (1) M¹ für Mg steht.

8. Das fluoreszierende Silikatmaterial gemäß einem der Ansprüche 1 bis 7, wobei in einem durch Messung der Thermolumineszenzintensität erhaltenen Thermolumineszenzspektrum ein Verhältnis TLa/TLp eines mittleren Thermolumineszenzintensitätswerts TLa in einem Bereich von 560 K oder mehr und 580 K oder weniger zu einem maximalen Thermolumineszenzintensitätswert TLp in einem Bereich von 240 K oder mehr und 350 K oder weniger 0,25 oder weniger beträgt.

9. Eine lichtemittierende Vorrichtung, umfassend:
das fluoreszierende Silikatmaterial gemäß einem der Ansprüche 1 bis 8; und
ein lichtemittierendes Element, welches das fluoreszierende Silikatmaterial mit Anregungslicht bestrahlt und eine Lichtemissions-Peakwellenlänge in einem Bereich von 300 nm oder mehr und 500 nm oder weniger aufweist.

10. Ein Verfahren zur Herstellung eines fluoreszierenden Silikatmaterials, umfassend:
das Mischen von Ausgangsmaterialien, einschließlich einer ersten Verbindung, welche mindestens ein erstes Alkalielement A¹ enthält, ausgewählt aus der Gruppe bestehend aus Rb und Cs, einer zweiten Verbindung, welche mindestens ein zweites Alkalielement A² enthält, ausgewählt aus der Gruppe bestehend aus K, Na und Li, einer dritten Verbindung, welche mindestens ein Element M¹ enthält, ausgewählt aus der Gruppe bestehend aus Mg, Ca, Sr, Ba, Y und La, einer vierten Verbindung, welche Li enthält, einer fünften Verbindung, welche Si enthält, und einer sechsten Verbindung, welche Eu enthält, wobei mindestens eine der Verbindungen von der ersten Verbindung bis zur sechsten Verbindung ein Oxid ist, um ein Ausgangsmaterialgemisch zu erhalten,
wobei das in der ersten Verbindung enthaltene erste Alkalielement A¹, das in der zweiten Verbindung enthaltene zweite Alkalielement A², das in der dritten Verbindung enthaltene Element M¹, das in der vierten Verbindung enthaltene Li, das in der fünften Verbindung enthaltene Si und das in der sechsten Verbindung enthaltene Eu Molverhältnisse in einer Zusammensetzung erfüllen, welche durch die nachstehende Formel (1) dargestellt wird; und
erstes Wärmebehandeln des Ausgangsmaterialgemischs bei einer ersten Temperatur in einem Bereich von 400 °C oder höher und 800 °C oder niedriger in einer reduzierenden Atmosphäre, um ein erstes wärmebehandeltes Produkt mit der durch die nachstehende Formel (1) dargestellten Zusammensetzung zu erhalten:
A¹_{1-w-x}A²_{w}M¹ₓ(Li₃SiO₄):Eu_{y} (1)
wobei w, x und y die Bedingungen 0 < w < 1,0, 0 < x ≤ 0,125, w+x ≤ 1,0 und 0 < y ≤ 0,08 erfüllen.

11. Das Verfahren zur Herstellung eines fluoreszierenden Silikatmaterials gemäß Anspruch 10, welches ferner das zweite Wärmebehandeln des ersten wärmebehandelten Produkts bei einer zweiten Temperatur in einem Bereich von 200 °C oder höher und 350 °C oder niedriger umfasst, um ein zweites wärmebehandeltes Produkt mit einer durch die Formel (1) dargestellten Zusammensetzung zu erhalten.

## Revendications

1. Matériau fluorescent silicaté ayant une composition représentée par la formule (1) suivante :
A¹_{1-w-x}A²_{w}M¹ₓ(Li₃SiO₄):Eu_{y} (1)
dans laquelle A¹ représente au moins un premier élément alcalin choisi dans le groupe constitué par Rb et Cs, A² représente au moins un deuxième élément alcalin choisi dans le groupe constitué par K, Na et Li, M¹ représente au moins un élément choisi dans le groupe constitué par Mg, Ca, Sr, Ba, Y, et La, et w, x, et y satisfont 0 < w < 1,0, 0 < x ≤ 0,125, w + x ≤ 1,0, et 0 < y ≤ 0,08.

2. Matériau fluorescent silicaté selon la revendication 1, dans lequel, dans la formule (1), w, x, et y satisfont 0,1 ≤ w ≤ 0,24, 0,01 ≤ x ≤ 0,125, et 0,01 ≤ y ≤ 0,08.

3. Matériau fluorescent silicaté selon la revendication 1 ou 2, dans lequel, dans la formule (1), x satisfait 0,02 ≤ x ≤ 0,125.

4. Matériau fluorescent silicaté selon l'une quelconque des revendications 1 à 3, dans lequel, dans la formule (1), A¹ comprend Rb, et A² comprend Na.

5. Matériau fluorescent silicaté selon la revendication 1, dans lequel, dans la formule (1), A¹ est Rb, et A² est Na.

6. Matériau fluorescent silicaté selon l'une quelconque des revendications 1 à 5, dans lequel, dans la formule (1), M¹ comprend Mg.

7. Matériau fluorescent silicaté selon la revendication 1, dans lequel, dans la formule (1), M¹ est Mg.

8. Matériau fluorescent silicaté selon l'une quelconque des revendications 1 à 7, dans lequel, dans un spectre de thermoluminescence obtenu en mesurant l'intensité de thermoluminescence, le rapport TLa/TLp d'une valeur moyenne d'intensité de thermoluminescence TLa dans une plage de 560 K ou plus et de 580 K ou moins à une valeur maximale d'intensité de thermoluminescence TLp dans une plage de 240 K ou plus et de 350 K ou moins est de 0,25 ou moins.

9. Dispositif électroluminescent, comprenant :
le matériau fluorescent silicaté selon l'une quelconque des revendications 1 à 8 ; et
un élément électroluminescent irradiant le matériau fluorescent silicaté avec une lumière d'excitation et ayant une longueur d'onde de pic d'émission lumineuse dans une plage de 300 nm ou plus et de 500 nm ou moins.

10. Méthode de production d'un matériau fluorescent silicaté, comprenant :
le mélange de matières premières comprenant un premier composé contenant au moins un premier élément alcalin A¹ choisi dans le groupe constitué par Rb et Cs, un deuxième composé contenant au moins un deuxième élément alcalin A² choisi dans le groupe constitué par K, Na, et Li, un troisième composé contenant au moins un élément M¹ choisi dans le groupe constitué par Mg, Ca, Sr, Ba, Y, et La, un quatrième composé contenant du Li, un cinquième composé contenant du Si, et un sixième composé contenant de l'Eu, dans laquelle au moins un composé du premier composé au sixième composé est un oxyde, pour obtenir un mélange de matières premières,
dans laquelle le premier élément alcalin A¹ contenu dans le premier composé, le deuxième élément alcalin A² contenu dans le deuxième composé, l'élément M¹ contenu dans le troisième composé, Li contenu dans le quatrième composé, Si contenu dans le cinquième composé et Eu contenu dans le sixième composé satisfont à des rapports molaires dans une composition représentée par la formule (1) suivante ; et
le premier traitement thermique du mélange de matières premières à une première température dans une plage de 400°C ou plus et de 800°C ou moins dans une atmosphère réductrice pour obtenir un premier produit traité thermiquement ayant la composition représentée par la formule (1) suivante :
A¹_{1-w-x}A²_{w}M¹ₓ(Li₃SiO₄):Eu_{y} (1)
dans laquelle w, x, et y satisfont 0 < w < 1,0, 0 < x ≤ 0,125, w + x ≤ 1,0, et 0 < y ≤ 0,08.

11. Méthode de production d'un matériau fluorescent silicaté selon la revendication 10, comprenant en outre un deuxième traitement thermique du premier produit traité thermiquement à une deuxième température dans une plage de 200°C ou plus et 350°C ou moins pour obtenir un deuxième produit traité thermiquement ayant une composition représentée par la formule (1).
